# FASCICULE DE BREVET EUROPEEN

(11) **EP 1 671 140 B1**
(45) Date de publication et mention de la délivrance du brevet: **16.05.2018**
(21) Numéro de dépôt: 04791508.7
(22) Date de dépôt: 08.10.2004
(51) Int. Cl.: G01R 33/02, G01R 33/09, G01R 31/00

(54) **DISPOSITIF DE MESURE D'UN CHAMP MAGNETIQUE**
VORRICHTUNG ZUR MESSUNG EINES MAGNETFELDES
MAGNETIC-FIELD-MEASURING DEVICE

(30) Priorité: 08.10.2003 FR 0311769
(43) Date de publication de la demande: 21.06.2006
(73) Titulaire: CENTRE NATIONAL D'ETUDES SPATIALES, 75001 Paris (FR)
(72) Inventeur: DESPLATS, Romain, 31320 Castanet Tolosan (FR); CREPEL, Olivier, 31880 La Savetat Saint Gilles (FR); BEAUDOIN, Félix, 31450 Baziège (FR); PERDU, Philippe, 31100 Toulouse (FR)
(74) Mandataire: Lavoix
(86) Numéro de dépôt international: PCT/FR2004/002561
(87) Numéro de publication internationale: WO 2005/036187

(56) Documents cités:
- WO-A2-03/076954
- DE-A- 19 812 307
- US-A- 4 465 974
- US-A- 4 995 165
- US-A- 5 351 005
- US-A- 5 880 586
- US-A- 6 118 284
- US-A1- 2001 043 065
- US-B1- 6 486 663

## Description

La présente invention concerne un dispositif de mesure d'un champ magnétique du type comportant un capteur magnéto-résistif ou magnéto-inductif et une chaîne de mesure dont une entrée est reliée au capteur magnéto-résistif ou magnéto-inductif et dont la sortie est propre à fournir une information représentative du champ magnétique dans la région du capteur.

Il est connu notamment par le document US 5 880 586 un appareil pour déterminer la position rotationnelle d'un arbre rotatif. Cet appareil comprend un aimant fixé à l'arbre rotatif, deux capteurs magnéto-résistifs propres à détecter le champ magnétique produit par l'aimant et à générer un signal de sortie représentatif de la position rotationnelle de l'arbre rotatif.

Il est connu, notamment par les documents US 6 486 663 et US 5 351 005, un circuit de détermination de l'angle α entre un champ magnétique extérieur B à mesurer et une direction prédéfinie comportant un capteur magnéto-résistif propre à mesure l'angle α et un circuit de correction de l'angle mesuré de manière à ce que cet angle soit indépendant des variations de température extérieure.

Il est connu notamment par le document US 4 995 165 un manomètre destiné à mesurer le cap.

Il est connu également par le document US 6 118 284 un système de mesure d'un champ magnétique comportant notamment une horloge.

Pour le contrôle des circuits intégrés, ou pour mesurer le rayonnement engendré par un circuit électrique en fonctionnement, il est connu de placer un ou plusieurs capteurs au-dessus du circuit afin de déterminer le champ magnétique ou électrique engendré par le fonctionnement du circuit. Pour la détection du champ magnétique, de telles installations mettent en oeuvre des antennes, ou des "SQUIDS" pour Superconducting Quantum Interference Device.

Depuis peu, il est envisagé de mesurer le champ magnétique engendré par un circuit électronique en fonctionnement par mise en oeuvre d'un capteur magnéto-résistif et, plus précisément, d'un capteur de type GMR (Giant Magnetic Resistor).

De tels capteurs magnéto-résistifs sont des éléments électroniques dont la résistance varie en fonction du champ magnétique dans lequel ils sont placés. Ces composants sont relativement directifs, de sorte que leur résistance varie seulement en fonction d'une composante du champ magnétique, cette composante s'étendant suivant l'axe privilégié de mesure du capteur.

Dans les installations connues actuellement, le capteur magnéto-résistif placé au-dessus du circuit électronique à analyser est relié à un analyseur de spectre et à un détecteur synchrone.

L'analyseur de spectre permet de déterminer, pour l'ensemble des fréquences d'une plage prédéterminée, la composante fréquentielle du signal issu du capteur magnéto-résistif.

Le détecteur synchrone assure quant à lui la synchronisation de la mesure à la sortie du capteur avec la fréquence de référence envoyée à l'entrée du même capteur.

L'obtention du résultat de la mesure est très long et peut atteindre 30 secondes. Ainsi, de telles installations ne peuvent être utilisées que pour effectuer un nombre restreint de mesures à la surface du circuit à analyser.

De plus, ces installations sont extrêmement coûteuses du fait de la présence d'un analyseur de spectre et d'un détecteur synchrone.

L'invention a pour but de proposer un dispositif de mesure d'un champ magnétique qui soit d'un coût réduit, et qui permette d'obtenir rapidement un résultat exploitable de la mesure.

A cet effet, l'invention a pour objet une installation d'analyse selon la revendication 1.

L'invention sera mieux comprise à la lecture de la description qui va suivre, donnée uniquement à titre d'exemple et faite en se référant aux dessins, sur lesquels :
- la figure 1 est une vue en perspective d'une installation d'analyse d'un circuit intégré ;
- la figure 2 est un organigramme explicitant le fonctionnement de l'installation de la figure 1 ;
- la figure 3 est une vue schématique d'un premier mode de réalisation d'un dispositif de mesure d'un champ magnétique selon l'invention ; et
- les figures 4 et 5 sont des vues identiques à la figure 3 de variantes de réalisation d'un dispositif de mesure.

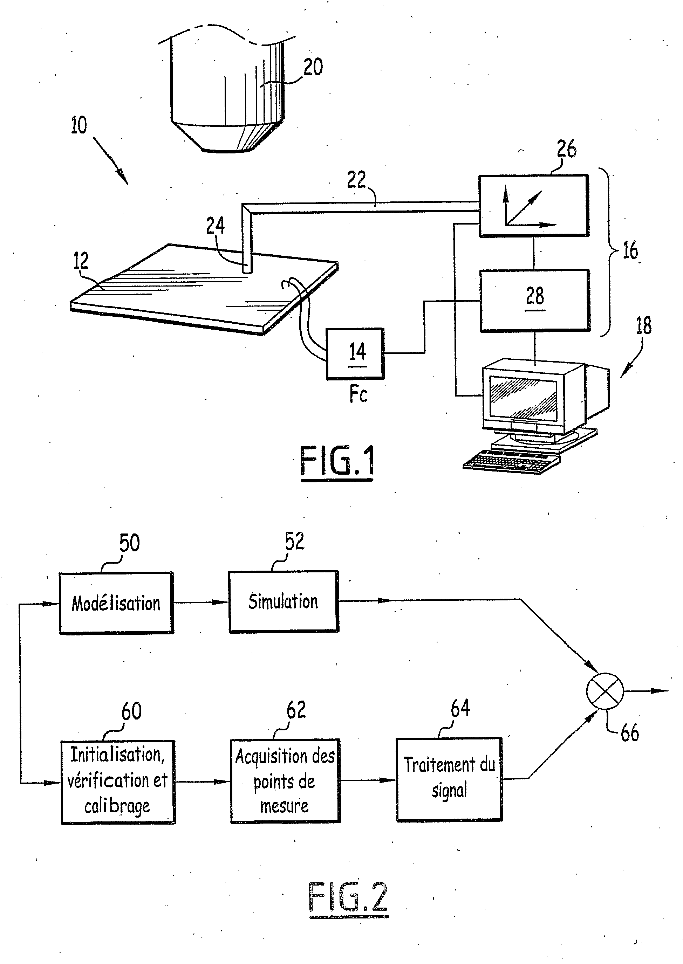

L'installation illustrée sur la figure 1 est destinée à l'analyse d'un circuit intégré en fonctionnement.

Cette installation comporte essentiellement un plateau 12 de support d'un circuit intégré C, un circuit 14 d'excitation du circuit intégré à une fréquence prédéterminée notée FC, un dispositif 16 d'analyse du champ magnétique engendré par le circuit C en fonctionnement et des moyens 18 d'exploitation des résultats obtenus en sortie du dispositif d'analyse du champ magnétique 16. En outre, l'installation comporte des moyens d'observation 20 du circuit intégré en fonctionnement. Ces moyens sont connus en soi et ne seront pas décrits en détail.

Le support 12 sur lequel est posé le circuit C est formé d'une plaque de mu-métal ou comporte dans sa partie inférieure opposée au circuit une plaque de mu-métal formant une barrière au champ magnétique. Avantageusement, le circuit C est confiné dans une boîte de mu-métal.

Le circuit d'excitation 14 est formé par exemple d'un générateur de fréquence propre à alimenter le circuit à la fréquence prédéterminée FC. Cette fréquence d'excitation FC est par exemple de 160 kHz.

Les moyens d'analyse 16 comportent un bras manipulateur 22 équipé, à son extrémité libre, d'une sonde de mesure 24 propre à déterminer une valeur caractéristique du champ magnétique à l'endroit de la sonde.

Le bras manipulateur 22 est relié à un mécanisme 26 de déplacement de la sonde, permettant, comme connu en soi, de déplacer celle-ci suivant trois directions perpendiculaires les unes aux autres et de connaître avec précision la position de la sonde par rapport au circuit.

En outre, les moyens d'analyse 16 comportent une chaîne de traitement 28 à laquelle est reliée la sonde 24 pour la mise en forme du signal issu de la sonde. Cette chaîne de traitement est reliée aux moyens d'exploitation 18 pour fournir à ceux-ci une ou plusieurs valeurs traitées du champ magnétique relevé par la sonde 24.

Les moyens d'exploitation 18 sont formés par exemple par un ordinateur de type PC comportant des cartes d'acquisition reliées en sortie de la chaîne de traitement 28. Il comporte en outre des cartes de commande permettant le pilotage des moyens d'analyse 16, et plus précisément, des moyens de déplacement 26, de la chaîne de traitement 28 et du circuit d'excitation 14.

Les moyens d'exploitation 18 comportent des modules logiciels permettant le pilotage des moyens d'analyse 16 du champ magnétique, et notamment du circuit d'excitation 14, des moyens de déplacement 26 et de la chaîne de traitement 28. Ils comportent en outre des modules logiciels de traitement des signaux issus des moyens d'analyse du champ.

En particulier, les moyens d'exploitation 18 sont propres à mettre en oeuvre l'algorithme illustré sur la figure 2, un module logiciel étant prévu pour chaque étape de l'algorithme.

Pour l'analyse d'un circuit électronique en fonctionnement, une modélisation du circuit peut d'abord être effectuée, à l'étape 50, à partir du tracé du circuit. Cette modélisation, par exemple vectorielle, est conduite à l'aide de tout logiciel adapté. Cette modélisation vise à déterminer la position des différentes pistes et des différents composants électroniques constituant le circuit C.

A l'issue de cette modélisation, une simulation du fonctionnement du circuit est effectuée à l'étape 52. Les caractéristiques du champ magnétique au-dessus du circuit sont déterminées par cette simulation, en chaque point du circuit, notamment par application des équations de Maxwell. Ainsi, il est déterminé, pour chaque élément du circuit, le courant circulant dans celui-ci, ainsi que les trois composantes du champ magnétique notées Bₓ, B_{y} et B_{z}, en un point de mesure situé immédiatement au-dessus du circuit et pour différentes positions prédéterminées pouvant être occupées par la sonde de mesure 24.

Parallèlement aux étapes de modélisation et de simulation, les moyens d'exploitation 18 commandent une mesure effective du champ magnétique par les moyens d'analyse du champ 16 en chaque point de mesure considéré lors de la simulation.

A l'étape 60, les moyens d'analyse du champ 16 sont d'abord initialisés et calibrés. Leur fonctionnement correct est également vérifié. En outre, des mesures de référence sont effectuées sur un échantillon de calibration connu dont les composantes du champ magnétique qu'il crée sont connues.

Une acquisition des différents points de mesure est ensuite effectuée à l'étape 62. Cette étape consiste à effectuer une mesure d'au moins une composante du champ magnétique en plusieurs points de mesure prédéterminés au-dessus du circuit C en fonctionnement. A cet effet, la sonde est déplacée sous la commande des moyens de déplacement 26 pour balayer la surface du circuit, par exemple en suivant un chemin en boustrophédon. Avant chaque acquisition d'une mesure, la sonde de mesure est arrêtée au point de mesure, afin que le résultat de la mesure ne soit pas affecté par le déplacement de la sonde.

L'acquisition proprement dite de chaque mesure sera décrite dans la suite.

Avantageusement mais non obligatoirement, l'étape 62 prévoit également l'acquisition de points de mesure alors que le circuit C n'est pas en fonctionnement, afin de mesurer en chaque point de mesure la ou les composantes du champ magnétique ambiant.

A l'étape 64, le signal acquis pour chaque point de mesure est traité afin notamment de corriger les erreurs et décalages résultant de la mesure, ces erreurs et décalages étant corrigés par des techniques de comparaison avec la table de données acquises sur un échantillon de référence, lors de l'étape 60.

Lors de l'étape 64, des valeurs issues des mesures du champ suivant une ou plusieurs directions notées Bₓ, B_{y}, B_{z} sont calculées et notamment les variations spatiales des composantes du champ suivant les trois directions notées dBₓ/dy, dBₓ/dz, dB_{y}/dz, dB_{y}/dx, dBz/dx et dB_{z}/dy.

En outre, les caractéristiques d'intensité et de direction du courant dans le circuit au-dessous du point de mesure sont déterminées par application de la loi de Maxwell J = Rot B où J est le vecteur courant et B le vecteur champ magnétique.

A l'étape 66, les valeurs issues de l'étape du traitement de signal 64 et les valeurs obtenues suite à la simulation effectuée à l'étape 52 sont comparées afin de déduire si le fonctionnement réel du circuit est correct ou non, et déterminer les zones de discordance entre le circuit théorique et le circuit réel en fonctionnement.

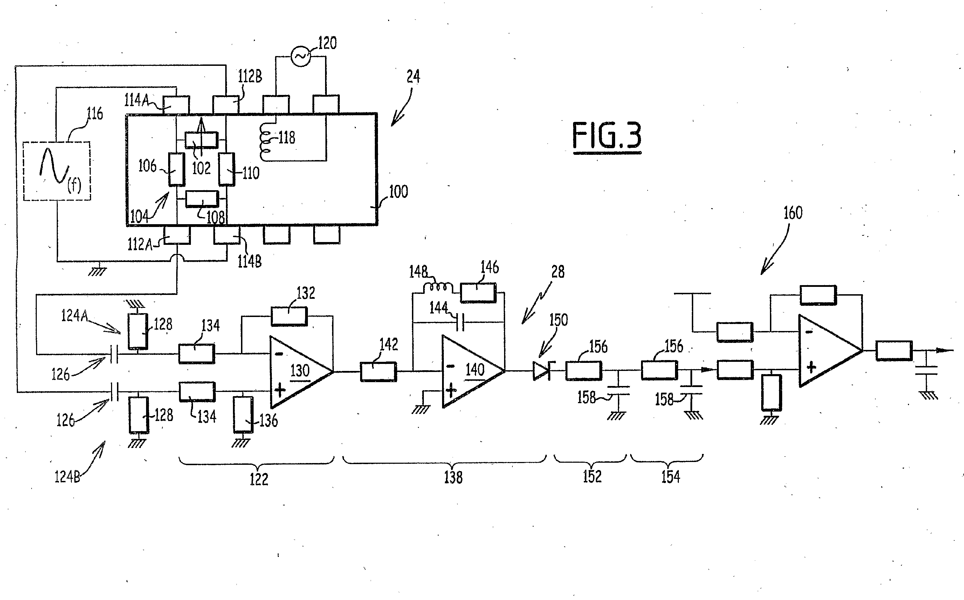

Sur la figure 3 sont représentés schématiquement les moyens d'analyse 16 du champ magnétique, et plus précisément, la sonde 24 et la chaîne de traitement 28 faite suivant un premier mode de réalisation de l'invention.

La sonde 24 illustrée sur cette figure est propre à mesurer la composante du champ magnétique suivant seulement une direction parallèle au plan du circuit 14. A cet effet, elle comporte un unique capteur magnéto-résistif.

En variante et avantageusement, la sonde comporte plusieurs capteurs magnéto-résistifs disposés suivant des directions décalées angulairement et avantageusement perpendiculaires les unes aux autres, chaque capteur étant relié à une chaîne de traitement propre 28 telle qu'illustrée sur la figure 3.

La tête de mesure 24 comporte une sonde de mesure 100 constituée d'un circuit intégré comportant un capteur magnéto-résistif noté 102. Ce capteur magnéto-résistif est un composant dont la résistance varie en fonction du champ magnétique dans lequel il se trouve. Un tel capteur présente un axe de mesure privilégié indiqué schématiquement par une flèche. La résistance du composant est influencée essentiellement par la composante du champ magnétique suivant cet axe de mesure privilégié.

Le capteur magnéto-résistif peut être de type GMR (Giant Magnéto Resistive), de type GMI (Giant Magnéto Impedance), de type CMR (Collossal Magnéto Resistive) ou de type TMR (Tunneling Magnéto Resistive). De préférence, le capteur magnéto-résistif est de ce dernier type. Il peut s'agir par exemple de capteurs de type MTJ (Magnetic Tunnel Junction) ou de type SDT (Spin Dépendent Tunneling).

Comme illustré sur la figure 3, le capteur magnéto-résistif 102 est intégré dans un pont de Weston 104 comportant trois autres résistances fixes 106, 108, 110 de valeurs prédéterminées. Les quatre résistances sont reliées en série pour former une boucle, comme connu en soi dans la structure d'un pont de Weston. Deux des bornes opposées du pont de Weston forment des sorties 112A, 112B de mesure de la sonde 100. Les deux autres bornes 114A, 114B du pont de Weston forment des entrées d'alimentation du pont de Weston. Celles-ci sont reliées aux bornes d'un générateur 116 produisant un signal sinusoïdal de fréquence prédéterminée notée f. Cette fréquence est très supérieure à la composante fréquentielle du champ que l'on cherche à déterminer. Elle est par exemple égale à 1,60 MHz.

En outre, et comme connu en soi, la sonde de mesure 100 comporte un bobinage 118 relié à une source extérieure de tension alternative 120. Le bobinage 118 est adapté pour créer un champ de polarisation dans la région du capteur magnéto-résistif afin de placer le capteur dans une zone de fonctionnement ou la sensibilité est optimale et l'hystérésis minimale.

Les sorties 112A, 112B de la sonde de mesure sont reliées à la chaîne de traitement 28.

Celles-ci sont reliées, en entrée, à un étage d'amplification différentielle 122 formant soustracteur par l'intermédiaire de deux filtres passe-haut 124A, 124B aux entrées desquelles sont connectées, respectivement, les bornes de sortie 112A et 112B.

L'étage d'amplification différentielle 122 est dimensionné pour produire un gain, par exemple égal à 100.

Les filtres passe-haut sont des filtres passifs de type RC comportant un condensateur 126 dont une borne est reliée à la masse par une résistance 128.

L'étage d'amplification différentielle est de tout type connu adapté et comporte, par exemple, un amplificateur opérationnel 130 dont la boucle de contre-réaction est équipée d'une résistance 132, les entrées inverseuses et non-inverseuses de l'amplificateur opérationnel étant reliées aux sorties des filtres 124A, 124B par deux résistances d'entrée 134. La borne non-inverseuse de l'amplificateur opérationnel est reliée à la masse par une résistance 136 fixant une tension d'entrée.

La sortie de l'amplificateur différentiel 120 est reliée à l'entrée de moyens 138 d'isolement d'une composante fréquentielle déterminée du signal représentatif du champ magnétique issu de la sonde de mesure. La fréquence de la composante du champ à déterminer est notée FI. Cette fréquence est par exemple égale à 160 kHz.

Dans le mode de réalisation illustré sur la figure 3, ces moyens d'isolement 138 comportent un filtre sélectif actif du type passe-bande centré sur la fréquence FI de la composante fréquentielle à isoler. Cette fréquence est égale à la fréquence F d'excitation du circuit C.

Ce filtre comporte un amplificateur opérationnel 140 dont la borne non-inverseuse est reliée à la masse. La borne inverseuse du filtre est reliée à la sortie de l'étage d'amplification différentielle 122 par une résistance d'entrée 142. La boucle de contre-réaction de l'amplificateur différentiel 140 comprend un condensateur 144 relié en parallèle à une résistance 146, elle-même connectée en série avec une bobine 148.

En sortie, le filtre sélectif 138 présente une diode 150 de type BAT suivie de deux filtres passe-bas passifs 152, 154, chacun formé d'une résistance dont la borne de sortie est reliée à la masse par un condensateur 158.

La chaîne de traitement 28 permet d'obtenir la composante fréquentielle du champ magnétique détecté par le capteur magnéto-résistif à l'aide d'un circuit très simple.

Lors du fonctionnement du dispositif de mesure du champ magnétique, la valeur de la résistance du capteur magnéto-résistif 102 varie en fonction de l'intensité du champ magnétique suivant l'axe de mesure privilégié du capteur. Ainsi, l'amplitude du signal mesuré aux bornes de sortie 112A, 112B varie en fonction du champ magnétique.

Les deux filtres passe-haut 124A, 124B assurent un filtrage des fréquences perturbatrices résultant de l'environnement extérieur.

Le circuit d'amplification différentielle 122 produit en sortie un signal dont l'intensité est proportionnelle à la différence de potentiel entre les deux bornes 122A, 122B. Le filtre sélectif 138 centré sur la fréquence d'excitation du circuit C assure l'isolement de la composante fréquentielle du champ pour cette fréquence.

Les deux filtres passe-bas 152, 154 assurent un nouveau filtrage permettant la suppression des composantes perturbatrices.

Un étage de sortie 160 peut avantageusement être ajouté de manière en enlever la valeur de tension continue mesurée au borne du capteur à vide. Pour cela un amplificateur différentiel est à nouveau utilisé. Le signal de sortie précédent est injecté sur l'entrée inverseuse de l'amplicateur différentielle. Alors que la tension continue de référence est injectée sur l'entrée non inverseuse.

Le réglage de la tension de référence se fait par ajustement de la valeur de la résistance ajustable de manière à mesure une valeur nulle en sortie de ce deuxième amplicateur différentiel. La mesure se fait en polarisant le capteur magnétiquement (pour se décaler dans le cycle d'hystérésis) sans polariser le circuit C.

Le signal issu de la chaîne de traitement est recueilli par les moyens d'exploitation 18.

Ainsi, on comprend que la chaîne de traitement permet l'obtention très rapide d'une valeur de mesure du champ magnétique et plus précisément d'une composante de ce champ magnétique.

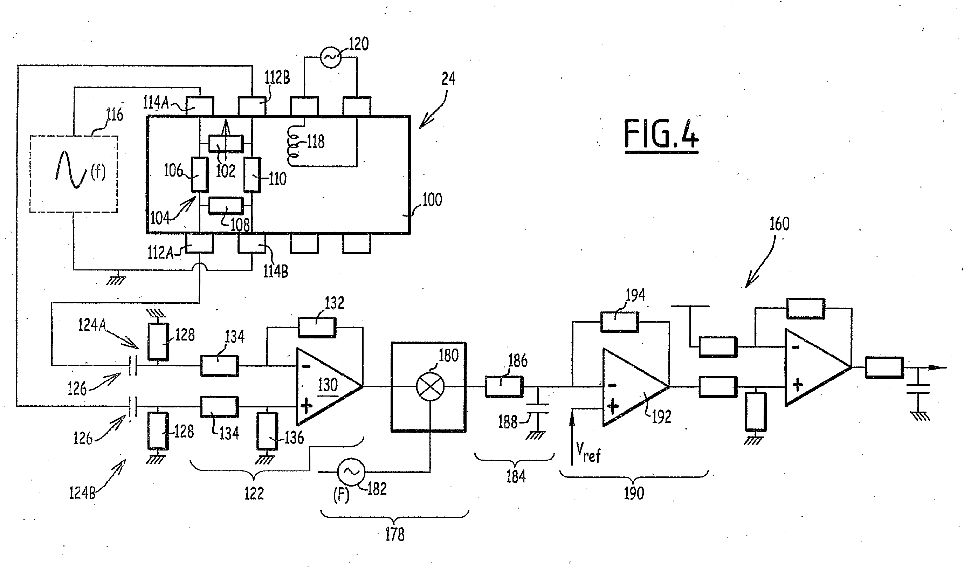

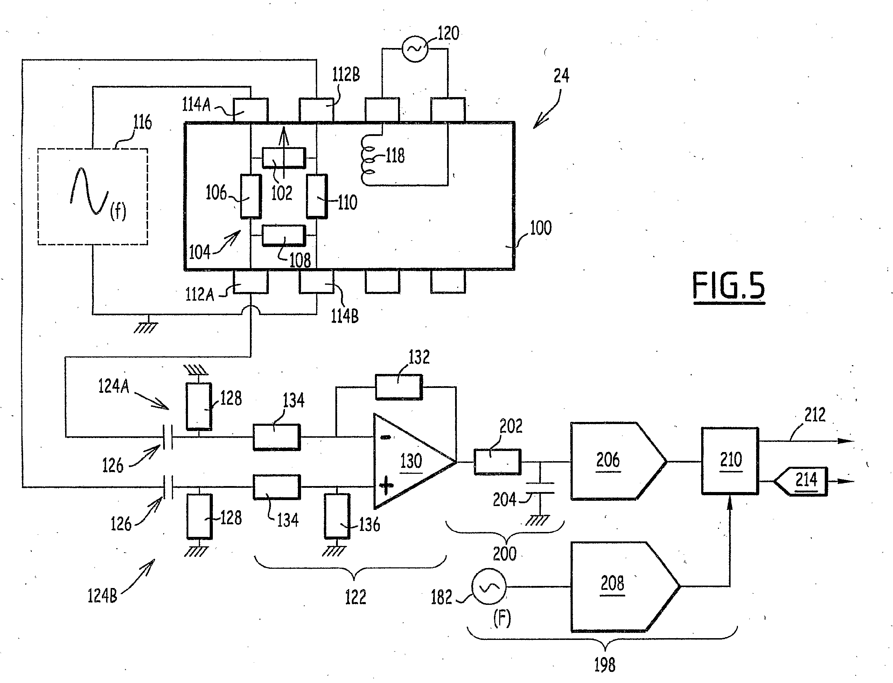

Sur les figures 4 et 5 sont représentées des variantes de réalisation d'un dispositif de mesure selon l'invention. Dans ces modes de réalisation, les éléments identiques ou analogues à ceux de la figure 3 sont désignés par les mêmes numéros de référence.

Dans ces deux variantes de réalisation, seule la chaîne de traitement diffère, par les moyens mis en oeuvre en aval de l'étage d'amplification différentielle 122.

Dans les deux cas, les moyens d'isolement de la composante fréquentielle du champ magnétique pour une fréquence prédéterminée comportent un circuit multiplicateur 180 permettant de combiner le signal issu de l'étage d'amplification différentielle 122 et un signal de référence, dont la fréquence FC est supérieure ou égale à la fréquence f de fonctionnement du circuit imposée par le circuit d'excitation 14. L'utilisation du multiplicateur donne de la flexibilité quant au choix de la fréquence (160 KHz)

Dans le mode de réalisation de la figure 4, les moyens d'isolement comportent un circuit multiplicateur analogique 180 dont une entrée est connectée en sortie de l'étage d'amplification différentielle 122 et dont l'autre entrée est reliée à un générateur de tension sinusoïdal 182 dont la fréquence de référence F est supérieure à la fréquence prédéterminée FI de la composante fréquentielle à isoler.

Un filtre passe-bas 184 constitué d'une résistance 186 et d'un condensateur 188 est prévu en sortie du circuit multiplicateur. Avantageusement, un circuit soustracteur 190 est prévu en sortie du filtre passe-bas 184 pour assurer la comparaison du signal filtré obtenu en sortie à un signal de référence noté Vref imposé. Le circuit soustracteur comporte un amplificateur opérationnel 192 dont la boucle de contre-réaction présente une résistance 194 adaptée et sur la borne non-inverseuse duquel une tension Vref est appliquée.

Comme dans le mode de réalisation de la figure 3, un étage de sortie 160 est disposé en sortie du circuit soustracteur.

Suivant un mode particulier de réalisation, la source de tension 182 est formée par la source de tension 116 alimentant le pont de Weston 104.

Dans ce mode la fréquence d'alimentation du capteur est identique à la fréquence de la composante fréquentielle recherchée.

Dans le mode de réalisation de la figure 5, les moyens d'isolement de la composante fréquentielle déterminée sont formés d'un calculateur numérique assurant la multiplication du signal obtenu en sortie de l'étage d'amplification différentielle 122 et d'un signal de référence.

Comme illustré sur la figure 5, un filtre passe-bas 200 constitué d'une résistance 202 et d'un condensateur 204 est prévu en sortie de l'étage d'amplification différentielle. Un convertisseur analogique/numérique 206 est connecté en sortie du filtre 200 afin d'assurer une numérisation du signal.

En outre, la chaîne de traitement intègre, comme précédemment, une source notée également 182, d'une tension sinusoïdale de référence. Un convertisseur analogique/numérique 208 est relié en sortie de cette source 182. Les convertisseurs analogiques/numériques ont une fréquence d'échantillonnage très supérieure à la fréquence des signaux reçus. Celle-ci est par exemple supérieure à 500 kHz.

Un calculateur rapide 210, tel qu'un circuit de type DSP est prévu dans la chaîne de traitement. Il reçoit en entrée les signaux issus des deux convertisseurs analogiques 206 et 208 et est programmé pour assurer une multiplication des deux signaux.

Les signaux multipliés sont ainsi adressés aux moyens d'exploitation 18, soit par une liaison numérique telle qu'une liaison de type RS232 notée 212, ou au travers d'une liaison analogique, un convertisseur numérique/analogique 214 étant relié en sortie du calculateur 210.

Dans ce cas, la multiplication des deux signaux est effectuée par le calculateur 210. L'opération de soustraction effectuée par l'étage de sortie 160 dans les figures 3 et 4 est également assurée par le calculateur 210.

En variante, les capteurs magnéto-résistifs sont remplacés par des capteurs magnéto-inductifs.

## Revendications

1. Installation d'analyse d'un champ magnétique engendré par un circuit en fonctionnement comportant :
- des moyens (14) d'excitation du circuit à une fréquence d'excitation prédéterminée (FC) ; et
- un dispositif de mesure (16) d'au moins une composante d'un champ magnétique comportant un capteur magnéto-résistif ou magnéto-inductif (102), et une chaîne de mesure (28) dont une entrée est reliée au capteur magnéto-résistif ou magnéto-inductif (102) et dont la sortie est propre à fournir une information représentative du champ magnétique dans la région du capteur ;
**caractérisée en ce que** la chaîne de mesure (28) comporte des moyens (138 ; 178 ; 198) d'isolement d'une composante fréquentielle du signal issu du capteur représentatif du champ magnétique pour une fréquence prédéterminée (FI) unique ;
**en ce que** le dispositif de mesure (16) comporte en outre un générateur (116) d'alimentation alternative du capteur magnéto-résistif ou magnéto-inductif (102) à une fréquence d'excitation (f), la fréquence d'excitation (f) étant supérieure ou égale à ladite fréquence prédéterminée (FI) de la composante fréquentielle à isoler ;
et **en ce que** la fréquence prédéterminée unique (FI) de la composante fréquentielle à isoler est égale à la fréquence (FC) d'excitation du circuit.

2. Installation selon la revendication 1, **caractérisée en ce que** ladite chaîne de mesure (28) comporte un filtre passe-bande (138) dimensionné pour isoler la seule composante fréquentielle à la fréquence prédéterminée unique (FI) du signal issu du capteur représentatif du champ magnétique.

3. Installation selon la revendication 2, **caractérisée en ce que** le filtre passe-bande (138) comporte un amplificateur opérationnel (130).

4. Installation selon la revendication 1, **caractérisée en ce que** la chaîne de mesure (28) comporte un générateur d'un signal de référence dont la fréquence (F) est supérieure ou égale à la fréquence prédéterminée unique (FI) de la composante fréquentielle à isoler, et **en ce qu'**il comporte un multiplicateur (180, 210) propre à assurer une multiplication du signal issu du capteur et du signal de référence.

5. Installation selon la revendication 4, **caractérisée en ce que** ledit multiplicateur (180) est adapté pour effectuer une multiplication analogique des deux signaux.

6. Installation selon la revendication 4, **caractérisée en ce que** la chaîne de mesure (24) comporte deux convertisseurs analogiques/numériques (206, 208) propres à assurer une conversion du signal issu du capteur et du signal de référence, ainsi qu'un calculateur numérique (210) propre à assurer la multiplication des deux signaux numériques issus des convertisseurs analogiques numériques (206, 210).

## Patentansprüche

1. Anordnung zum Analysieren eines magnetischen Feldes, das von einer Schaltung im Betrieb verursacht wird, aufweisend:
- Mittel (14) zum Anregen der Schaltung mit einer vorgegebenen Anregungsfrequenz (FC); und
- eine Vorrichtung zum Messen (16) mindestens einer Komponente eines magnetischen Feldes mit einem magnetoresistivem oder magnetoinduktivem Sensor (102) und einer Messungskette (28) deren einer Eingang mit dem magnetoresistivem oder magnetoinduktivem Sensor (102) verbunden ist und deren Ausgang eingerichtet ist, eine Information bereitzustellen, die das magnetische Feld in dem Bereich des Sensors repräsentiert;
dadurch charakterisiert, dass die Messungskette (28) Mittel (138; 178; 198) zum Isolieren einer Frequenzkomponente des von dem Sensor ausgegebenen Signals, das für das magnetische Feld für eine vorgegebene einzelne Frequenz (FI) repräsentativ ist, aufweist;
dadurch, dass Vorrichtung zum Messen (16) außerdem einen Generator (116) zur Wechselstromversorgung des magnetoresistiven oder magnetoinduktiven Sensors (102) bei einer Anregungsfrequenz (f) aufweist, wobei die Anregungsfrequenz (f) größer oder gleich der vorgegebenen Frequenz (FI) der zu isolierenden Frequenzkomponente ist;
und dadurch, dass die vorgegebene einzelne Frequenz (FI) der zu isolierenden Frequenzkomponente gleich der Anregungsfrequenz (FC) der Schaltung ist.

2. Anordnung gemäß Anspruch 1, dadurch charakterisiert, dass die Messungskette (28) ein Bandpassfilter (138) aufweist, dass zum Isolieren der einzigen Frequenzkomponente mit der einzelnen vorgegebenen Frequenz (FI) des von dem Sensor ausgegebenen Signals, das für das magnetische Feld repräsentativ ist, dimensioniert ist.

3. Anordnung gemäß Anspruch 2, dadurch charakterisiert, dass das Bandpassfilter (138) einen Operationsverstärker (130) aufweist.

4. Anordnung gemäß Anspruch 1, dadurch charakterisiert, dass die Messungskette (28) einen Generator eines Referenzsignals aufweist, dessen Frequenz (F) größer oder gleich der vorgegebenen einzelnen Frequenz (FI) der zu isolierenden Frequenzkomponente ist und dadurch, dass sie einen Multiplikator (180, 210) aufweist, der dazu geeignet ist, eine Multiplikation des von dem Sensor ausgegebenen Signals und des Referenzsignals zu gewährleisten.

5. Anordnung gemäß Anspruch 4, dadurch charakterisiert, dass der Multiplikator (180) eingerichtet ist, eine analoge Multiplikation der zwei Signale durchzuführen.

6. Anordnung gemäß Anspruch 4, dadurch charakterisiert, dass die Messungskette (24) zwei Analog/Digital-Wandler (206, 208), die dazu geeignet sind, eine Umwandlung des von dem Sensor ausgegebenen Signals und des Referenzsignals zu gewährleisten, sowie einen Digitalrechner (210) aufweist, der geeignet ist, die Multiplikation der zwei von den Analog/Digital-Wandlern (206, 210) ausgegebenen digitalen Signale zu gewährleisten.

## Claims

1. Installation for analysing a magnetic field produced by a circuit during operation comprising:
- means (14) for exciting the circuit at a predetermined excitation frequency (FC) ; and
- a measurement device (16) for measuring at least one component of a magnetic field comprising a magnetoresistive or magnetoinductive sensor (102) and a measurement chain (28), one input of which is connected to the magnetoresistive or magnetoinductive sensor (102) and the output of which is able to provide a piece of information representative of the magnetic field in the region of the sensor;
**characterised in that** the measurement chain (28) comprises means (138 ; 178 ; 198) for isolating a frequency component of the signal from the sensor representative of the magnetic field for a single predetermined frequency (FI);
**in that** the measurement device (16) comprises an alternating power supply generator (116) for the magnetoresistive or magnetoinductive sensor (102) at an excitation frequency (f), the excitation frequency (f) being greater than or equal to the predetermined frequency (FI) of the frequency component to be isolated;
and **in that** the single predetermined frequency (FI) of the frequency component to be isolated is equal to the excitation frequency (FC) of the circuit.

2. Installation according to claim 1, **characterised in that** the measurement chain (28) comprises a band-pass filter (138) which is configured so as to isolate only the frequency component at the single predetermined frequency (FI) of the signal from the sensor representative of the magnetic field.

3. Installation according to claim 2, **characterised in that** the band-pass filter (138) comprises an operational amplifier (130).

4. Installation according to claim 1, **characterised in that** the measurement chain (28) comprises a generator for a reference signal whose frequency (F) is greater than or equal to the single predetermined frequency (FI) of the frequency component to be isolated, and **in that** it comprises a multiplier (180, 210) which is able to bring about a multiplication of the signal from the sensor and the reference signal.

5. Installation according to claim 4, **characterised in that** the multiplier (180) is suitable for carrying out an analogue multiplication of the two signals.

6. Installation according to claim 4, **characterised in that** the measurement chain (24) comprises two analogue/digital converters (206, 208) which are able to bring about a conversion of the signal from the sensor and the reference signal, as well as a digital processor (210) which is able to bring about the multiplication of the two digital signals from the analogue/digital converters (206, 210).
